# EUROPEAN PATENT SPECIFICATION

(11) **EP 3 196 586 B1**
(45) Date of publication and mention of the grant of the patent: **12.09.2018**
(21) Application number: 17150422.8
(22) Date of filing: 05.01.2017
(51) Int. Cl.: F28F 13/06, F28D 15/02, F28F 1/02, H05K 7/20

(54) **POWER-ELECTRONIC MODULE ARRANGEMENT**
ANORDNUNG EINES LEISTUNGSELEKTRONISCHEN MODULS
ARRANGEMENT D'UN MODULE DE PUISSANCE ÉLECTRONIQUE

(30) Priority: 07.01.2016 EP 16150437
(43) Date of publication of application: 26.07.2017
(73) Proprietor: ABB Schweiz AG, 5400 Baden (CH)
(72) Inventor: Gradinger, Thomas, 5032 Aarau Rohr (CH); Agostini, Bruno, 8006 Zürich (CH); Agostini, Francesco, 8005 Zürich (CH); Habert, Mathieu, 68170 Rixheim (FR); Torresin, Daniele, 5413 Birmenstorf (CH)
(74) Representative: ABB Patent Attorneys

(56) References cited:
- EP-A1- 2 031 332
- EP-A1- 2 284 846
- EP-A1- 2 645 040
- EP-A1- 2 703 763
- EP-A1- 2 704 190
- EP-A1- 2 811 251
- EP-A1- 2 819 279
- JP-A- H0 566 096
- JP-A- H10 261 887
- JP-A- 2002 058 117
- JP-A- 2002 124 612
- JP-A- 2003 262 443
- JP-A- 2004 241 580
- US-A1- 2007 295 492

## Description

### Technical Field

The invention relates in general to power-electronic module arrangements including cooling units with heat exchangers.

### Background Art

In a typical power-electronic system, power-electronics components such as integrated (i.e. module type) semiconductor devices, inductors, resistors, capacitors and copper bus-bars are assembled in close proximity. PCB panels and control electronics are also present in all designs. During operation, these components dissipate heat of varying quantities. In addition, these components are subjected to temperatures of varying levels. The thermal management and integration concept of a drive system has to consider the occurring temperature ranges.

For power-electronic (PE) systems in the lower and medium power range, air cooling is an often used solution due to its simplicity, robustness and low investment cost. It is, however, limited in cooling performance compared to water cooling.

Another attractive cooling option is passive two-phase cooling. Here, an evaporator is in thermal contact with a heat source, typically a semiconductor module. The vaporized two-phase fluid is guided to a condenser, where the fluid returns back to liquid state, transferring the heat to ambient air. The motion of two-phase fluid is driven by gravity, pressure pulsations or capillary forces, and does not use a mechanical pump. The two-phase fluid is filled at production and the cooler is hermetically closed, such that it is maintenance free over its lifetime.

EP 2 645 040 A1 discloses a heat exchanger, comprising a first heat exchanger module with a first evaporator channel and a first condenser channel, wherein the first evaporator channel and the first condenser channel are arranged in a first conduit.

EP 2 819 279 A1 discloses an electric apparatus with at least two cooling elements and a first fan arrangement for cooling the at least two cooling elements with a first air flow, and a second fan arrangement for cooling the at least two cooling elements with a second air flow.

EP 2 284 846 A1 discloses a power unit with a heat producing unit having a heat source, and with a cooling unit comprising at least one heat exchanger device and at least a portion of a secondary chamber. The at least one heat source is thermally connected to the at least one heat exchanger device.

JP H10 261887 discloses a boiling cooler for a panel cooler. JP2002/124612 A describes an evaporative cooler.

EP 2 703 763 A1 discloses an evaporator with integrated pre-heater for power electronics cooling.

Like in air cooling, in two-phase cooling the heat is ultimately transferred to air. However, the intermediate step via the two-phase fluid avoids the heat-spreading problem in classical, conduction-based air cooling (air-cooled heat sinks). Therefore, with two-phase cooling, higher cooling performance and heat flux can be achieved than with air cooling. However, cost considerations and the challenging integration and orientation of a two-phase system into power-electronic systems restrict the application of two-phase cooling systems in power-electronic systems.

### Brief Summary of the Invention

In view of the above, a power-electronic module arrangement according to claim 1 is provided. Further aspects, advantages, and features of the present invention are apparent from the dependent claims, the description, and the accompanying drawings.

The power electronic module arrangement according to the invention includes a plurality of cooling units.

Each cooling unit includes a two-phase heat exchanger including a plurality of tube elements extending in a width direction of the cooling unit, within and communicating between an evaporator portion and a condenser portion of the cooling unit. Typically, the tube elements are arranged in a spaced-apart manner along a depth direction of the cooling unit forming cooling paths for allowing an external cooling medium to flow through the cooling paths for cooling a working medium within the at least one tube element. The cooling paths traverse the condenser portion in a length direction of the cooling unit. The cooling unit further includes flow guides for forcing an external cooling medium arriving at the heat exchanger from outside of the cooling unit through the cooling paths and then away from the cooling unit. The power electronic module arrangement further includes a plurality of semiconductor modules stacked in a length direction of each cooling unit, wherein flow guides of the cooling units block the flow of the cooling medium at one side of a two-phase heat exchanger in length direction. According to the invention, the flow guides of the cooling units of the plurality of cooling units block the flow of cooling medium between neighboring cooling units alternately at a first side of the cooling unit in depth direction and a second side of the cooling unit opposite to the first side in the depth direction.

The cooling unit suitable for embodiments described herein enables the integration of a two-phase heat exchanger into an air cooled power-electronic system (such as a power-electronic converter), in particular in a system, where the semiconductors are arranged in stacks. The incentive is increased cooling performance that can be used in various ways. For instance, the current rating can be increased (and, hence, the losses can be increased) at constant junction temperature and/or an increased switching frequency (and, hence, increasing switching losses) and reduced filter sizes can be realized at constant temperature. Alternatively, a lower temperature and, hence, an increased reliability and lifetime at constant current rating can be achieved when using the heat exchanger suitable for embodiments described herein. A further benefit of a cooling unit with a two-phase heat exchanger suitable for embodiments described herein may be a rating for higher ambient temperature of the power-electronic system for fixed junction temperature. According to some embodiments, a reduced air-flow rate, fan power and acoustic noise can be used for a fixed junction temperature. In addition, weight savings can be realized compared to the relatively bulky aluminum extruded heat sinks.

Thus, with the power-electronic module arrangement according to embodiments described herein, several effects can be induced allowing an efficient use of a two-phase heat exchanger with additional cooling fluid flow in a power-electronic system, in particular a system including a semiconductor stack.

### Brief Description of the Drawings

The subject matter of the invention will be explained in more detail in the following text with reference to exemplary embodiments which are illustrated in the drawings, in which:
Figure 1 shows a schematic cross-sectional top view of a cooling unit with a two-phase heat exchanger suitable for embodiments described herein;
Figure 2 shows a schematic front view of a cooling unit with a stack of two-phase heat exchangers with flow guides suitable for embodiments described herein;
Figure 3 shows a schematic sectional view of a cooling unit along line A-A shown in Figure 2 suitable for embodiments described herein;
Figure 4 shows a schematic front view of a cooling unit with a stack of two-phase heat exchangers with flow guides suitable for embodiments described herein;
Figure 5 shows a schematic sectional view of a cooling unit along line A-A shown in Figure 4 suitable for embodiments described herein;
Figure 6 shows a schematic front view of a cooling unit with a stack of two-phase heat exchangers with flow guides suitable for embodiments described herein;
Figure 7 shows a schematic sectional view of a cooling unit along line A-A shown in Figure 6 suitable for embodiments described herein;
Figure 8 shows a schematic sectional view of a two-phase heat exchanger in a stack of semiconductor modules suitable for embodiments described herein;
Figure 9 shows a partial sectional view of a two-phase heat exchanger of a cooling unit suitable for embodiments described herein;
Figure 10 shows a schematic perspective sectional view of a two-phase heat exchanger of a cooling unit suitable for embodiments described herein;
Figure 11 show a schematic view of a pool boiling situation in a tube element; and
Figure 12 shows a schematic view of a convection boiling situation in a tube element suitable for embodiments described herein.

The reference symbols used in the drawings, and their meanings, are listed in summary form in the list of reference symbols. In principle, identical parts are provided with the same reference symbols in the figures.

### Embodiments of the Invention

In the following, various aspects and embodiments of the invention are described. It is intended that each of the aspects, whether described in the context of a particular embodiment or of other features or not, can be combined with any other aspect.

In the Figures and the following description, the same reference numbers are used for analogous elements, and the description of any embodiment relating to the same reference sign is applicable to any other embodiment unless mentioned otherwise and/or unless the description would be inconsistent with that embodiment.

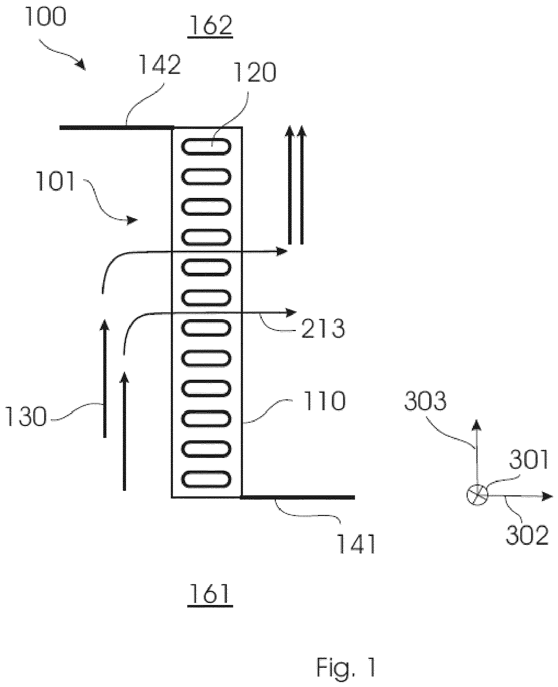

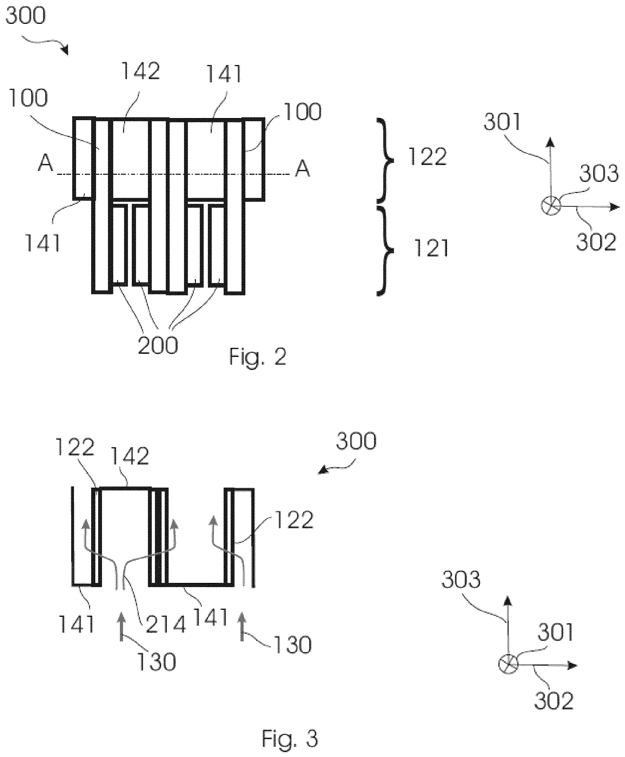

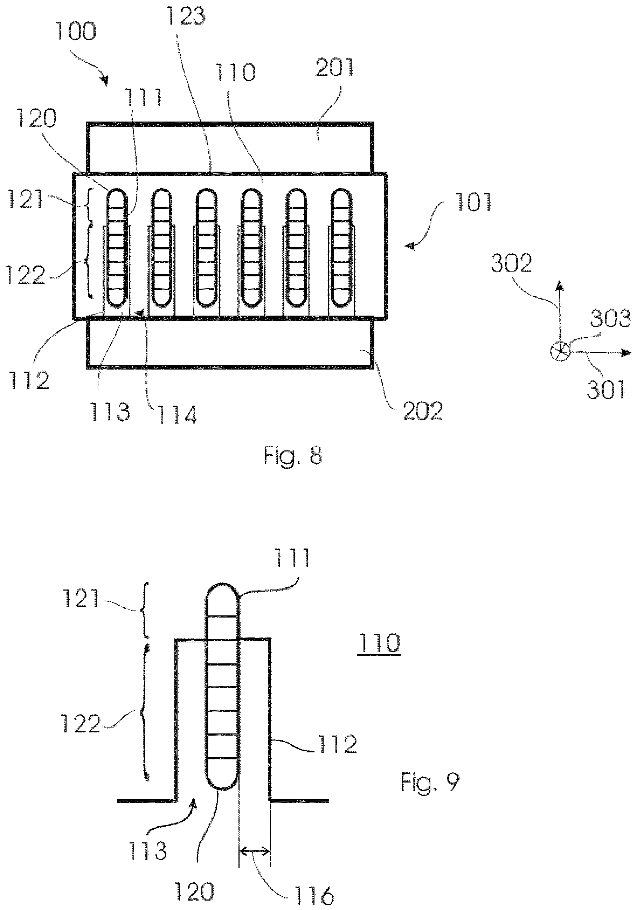

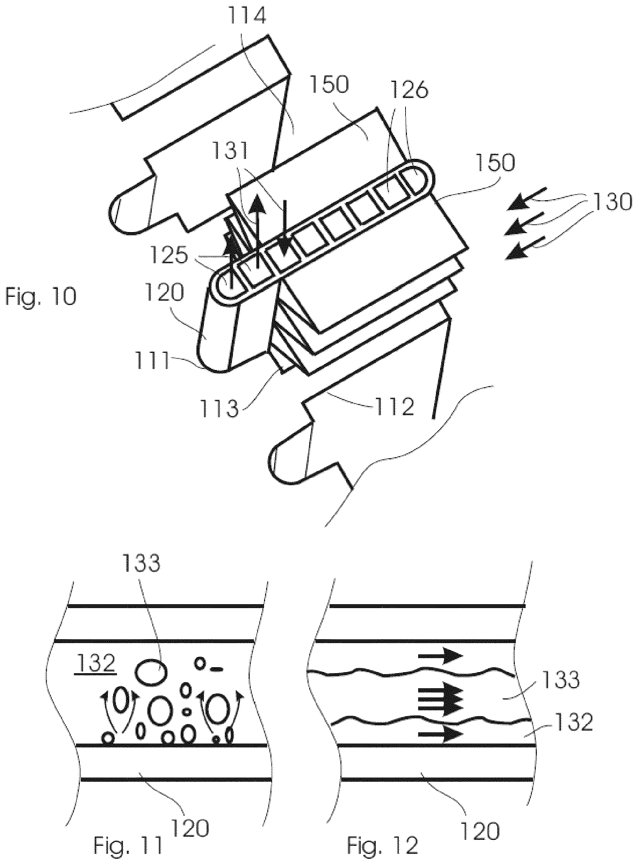

Figure 1 shows a cooling unit 100 including a two-phase heat exchanger 101 suitable for embodiments described herein. Typically, the two-phase heat exchanger 101 includes a plurality of tube elements 120 extending in particular in a width direction 301 of the cooling unit 100. As employed in some embodiments, the width direction 301 runs into the plane of projection in Figure 1. A tube element 120 of the two-phase heat exchanger 101 extends within and communicates between an evaporator portion 121 and a condenser portion 122 of the cooling unit 100. The evaporator portion 121 and the condenser portion 122 can be seen in Figures 2, 4, 6, and 8. In the Figures 8, 9 and 10 (which will be referred to in detail below), the tubes 120 are shown being sectioned into channels, i.e. channels of the evaporator portion 121and channels of the condenser portion 122. In Figure 10, the evaporator channels are denoted with reference sign 125 and the condenser channels are denoted with reference sign 126. As employed in some embodiments described herein, a tube 120 of the two-phase heat exchanger 101 is located within the evaporator portion 121 as well as the condenser portion 122 of the cooling unit 100. Also, the tube 120 may be able to communicate between the condenser portion 122 and the evaporator portion 121, e.g. a working medium flowing within the tube 120 from the evaporator portion to the condenser portion and vice versa. The condenser portion 122 and the evaporator portion 121 will be referred to and explained in detail below.

As employed in some embodiments described herein, the tube elements 120 are arranged spaced-apart from each other along a depth direction 303 of the cooling unit 100. Between the tube elements 120, cooling paths 213 are formed allowing an external cooling medium 130 to flow through the cooling paths 213. Typically, the cooling paths 213 allow for cooling a working fluid within the tube element(s) 120. The cooling paths 213 thereby traverse the condenser portion 122 in or parallel to a length direction 302 of the cooling unit 100 (crossing a plane formed by the directions 301 and 303). Length direction 302 is also denoted as stacking direction in embodiments described herein. Typically, by traversing the condenser portion 122 of the cooling unit 100, the condensation in the condenser portion is increased by the cooling effect of the external cooling medium 130 flowing through the flow paths 213 and past the condenser portion 122 of the tubes.

As employed in some embodiments described herein, the flow guides 141, 142 are configured for receiving the external cooling medium 130 arriving at or flowing towards the heat exchanger 101 from a direction essentially perpendicular to the length direction 302, preferably along the direction 303, and/or for releasing the cooling medium to a direction essentially perpendicular to the length direction 302, preferably along the depth direction 303 and/or the width direction at an opposite side of the incoming cooling medium.

Flow guides 141, 142 are provided for forcing the external cooling medium 130 arriving at or flowing towards the two-phase heat exchanger 101 from outside of the cooling unit 100 through the cooling paths 213 and then away from the cooling unit 100. As employed in some embodiments described herein, the flow guides may substantially extend in a length direction 302 of the cooling unit 100 (or stacking direction 302) as shown in Figure 1.

In Figure 1, a base plate 110 of the two-phase heat exchanger 101 can be seen in the background. As employed in some embodiments, the base plate may have grooves for forming a gap between a part of the condenser portion of the tube and the base plate (not shown in Figure 1), as will be explained in detail below. As employed in some embodiments, the evaporator portion 121 of the cooling unit 100 may be located within the base plate 110, in particular in a groove in the base plate 110 as will be explained in detail below.

As can be seen in Figure 1, a first flow guide 141 is placed at a first side 161 of the cooling unit 100 in depth direction 303. A second flow guide 142 is placed at a second side 162 of the cooling unit 100 in depth direction 303. Typically, the second side 162 is opposite to the first side 161 in depth direction 303. As is shown in Figure 1, the two flow guides 141 and 142 are provided at different positions of the cooling unit 100 in a length direction 302. The first flow guide 141 is provided at a first end of the cooling unit 100 in length direction, and the second flow guide 142 is provided at a second end of the cooling unit 100 in length direction. Typically, the first end and the second end of the cooling unit 100 is provided opposite to each other in the length direction 302.

As employed in some embodiments, the flow guides may be provided by any element suitable for guiding the external cooling medium 130 in the desired way. For instance, the flow guides may be provided by a sheet made of a suitable material or the like.

As can be seen in Figure 1, the external cooling medium 130 (which may, for instance, be a gaseous medium like air or the like) may be guided on a desired flow path through the cooling unit 100. The flow of the external cooling medium 130 cools the condenser portion 122 of the cooling unit at the flow path 213, and may finally be sucked upwards (in the width direction 301), and in particular expelled by fans mounted on the cabinet roof of the power-electronic system.

The flow path of the external cooling medium 130 through the cooling unit 100 is described has having an S-shape (in the example of Figure 1, the S-shape is mirror inverted). Typically, the pressure drop through the condenser portion of the cooling unit is rather low, in particular lower than that of known air-cooled heat sinks. The lower pressure may be used to compensate the additional pressure drop that arises through the S-shape of the air-flow path as employed in embodiments described herein.

The flow path of the external cooling medium 130, as employed in some embodiments described herein, is beneficial in terms of compactness and cooling performance. The described flow path may therefore be used in many power-electronic systems that are integrated in cabinets. In particular, the two-phase heat exchangers, which may be cooled by the external or second cooling medium, are advantageously arranged in parallel in the flow path of the second cooling medium, which avoids thermal stacking of the stack of semiconductor modules as employed in some embodiments described herein.

Figures 2 and 3 show an arrangement 300 of cooling units 100 in a stack of semiconductor modules 200 as employed in some embodiments described herein. As described before, the cooling units 100 each include a two-phase heat exchanger and flow guides. Figure 2 is a front view of the arrangement and Figure 3 is a sectional view along line A-A as for instance shown in Figure 2. As shown in Figures 2 and 3, the cooling units 100 are clamped between semiconductor modules 200 forming a stack of semiconductor modules. An external cooling medium 130, such as air, enters the arrangement 300 (or a cabinet of the power-electronic system) in a depth direction 303, which is the direction into the plane of projection in Figure 2. The external cooling medium 130 typically flows from front to back of the arrangement 300, as can be seen in Figure 3 in a more detailed manner.

The arrangement of the two-phase heat exchanger and the stack of semiconductor modules as employed in some embodiments described herein may result in the external or second cooling medium flowing in an S-shaped flow path 214 through the arrangement, as shown by arrows 130 in Figure 3. For forcing the flow of the external cooling medium along a flow path 214 as shown, the space between the two-phase heat exchangers are blocked by flow guides 141, 142 as described above, in particular alternately in front of the condenser portion 122 of the cooling unit, and in the back of the condenser portion 122 of the cooling unit. The flow guide being arranged in front of the cooling unit in depth direction 303 is denoted with reference sign 141, and the flow guide being arranged in back of the cooling unit in depth direction 303 is denoted with reference sign 142. Further flow guides may be provided, e.g. including vertical and horizontal plates that run from front to back in depth direction, such that respective channels for a desired flow path 214 can be formed. As employed in some embodiments, the flow path 214 between adjacently stacked two-phase heat exchangers may include the cooling path 213 (as for instance shown in Figure 1) between the tube elements 120 of a two-phase heat exchanger.

In Figures 2 and 3, the cooling units 100 with the two-phase heat exchangers are sandwiched between the semiconductor modules 200. For instance, Figure 2 shows a sequence of two-phase heat exchangers (or coolers C) and semiconductor modules (S) of CSSCCSSC. The exemplarily shown sequence means that each semiconductor module 200 is cooled only from one side. In the arrangement 300, typically, a bus bar (not drawn in the figure) is clamped between the adjacent semiconductors.

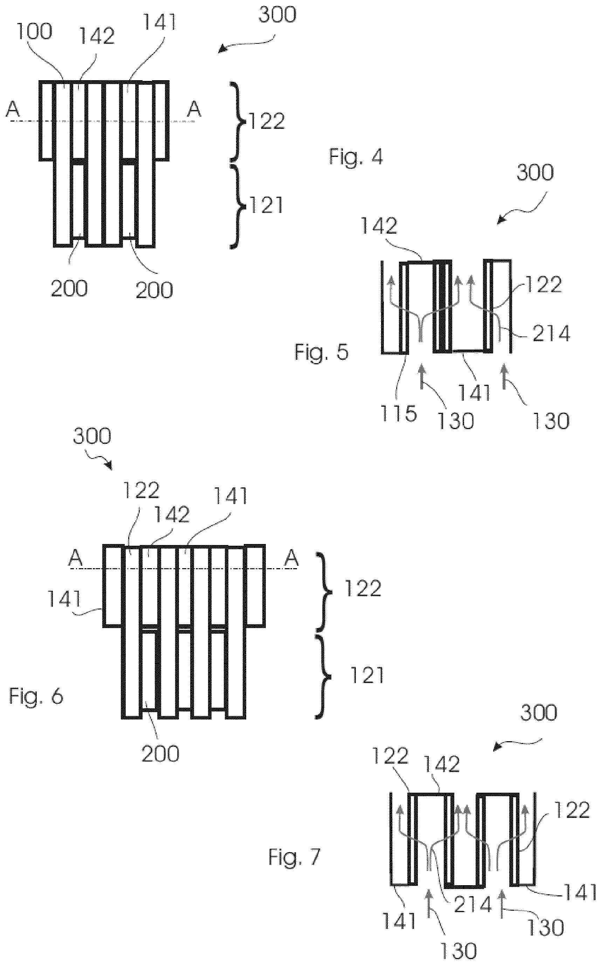

Figures 4 and 5 show alternative arrangements of cooling units 100 in a stack of semiconductor modules 200 as employed in some embodiments described herein. The cooling units 100 each include a two-phase heat exchanger and flow guides as employed in embodiments described herein. Figure 4 is a front view of the arrangement 300 and Figure 5 is a sectional view along line A-A as for instance shown in Figure 4. Figures 4 and 5 show arrangements suitable for some embodiments, in which the sequence of cooling units 100 (or cooler C) and semiconductor module (S) is CSCCSC. The arrangement 300 of Figures 4 and 5 allows for two-sided cooling of each semiconductor module 200.

Figures 6 and 7 show an arrangement 300 of cooling units 100 and semiconductor modules 200 as employed in some embodiments described herein. The sequence of cooling units and semiconductor modules is CSCSCSC in Figures 6 and 7. Generally, one-side or two-side cooling of a semiconductor module may depend on the orientation of the cooling units with respect to the semiconductor modules. For instance, the cooling units as employed in some embodiments described herein may provide a more efficient side (such as first side 123 of the base plate in Fig. 8) and a less efficient side (side of the base plate opposite to the first side 123). The more efficient side is the side considered to provide the best cooling effect. A semiconductor module arrangement as shown in Figures 6 and 7 may thus be in contact with one more effective side of a first cooling unit and one less effective side of a second cooling unit or with the more effective sides of both cooling units, depending on the orientation of the cooling unit. In the example shown in Figures 6 and 7, the semiconductor module at the right side is two-sided cooled, and the rest of the semiconductor modules are one-sided cooled. The one-side cooling and/or the two-side cooling may be chosen as desired to achieve a desired cooling performance as employed in some embodiments described herein.

As employed in some embodiments described herein, the two-phase heat exchanger device(s) of the cooling unit suitable for embodiments described herein are planar and are, when clamped into the stack of semiconductor modules, normal to the stacking direction 302. Generally, the stacking direction may either be horizontal (left-right), or vertical (although the figures only show a horizontal stacking direction). Typically, the base plate 110 (which for instance may provide a gap between a part of the condenser portion of the tube and the base plate) allows for stacking the two-phase heat exchangers and the stack of semiconductor modules properly.

As explained before, an air cooling system is often chosen in nowadays power-electronic systems. In order to obtain a competitive advantage, it is not necessarily sufficient that a cooling unit is more performant than today's used systems. It is desired that the cooling unit is also cheaper than known systems.

As employed in some embodiments, in order to achieve a significant cost advantage compared to known systems, a cheap two-phase cooling system is chosen, combined with an open air cooling of the electrical room, in which the power-electronic system is installed. Furthermore, the evaporator channel(s) and the condenser channel(s) may be integrated into a single piece, which avoids manual production steps such as the mounting of the different channels to a tube element.

Even though two-phase heat exchangers have been found to be comparatively inexpensive and performant as a component, various attempts to integrate it into a cooling unit for power-electronic systems have been unsuccessful in the past.

For instance, if a thermosyphon system is chosen as a two-phase heat exchanger of a cooling unit, the two-phase heat exchanger may be gravity-driven and and may be oriented such that the condenser is at the top, and the evaporator at the bottom. Furthermore, the form factor of a thermosyphon system is different from air-cooled heat sinks. Also, some examples of a thermosyphon system are rather flat, i.e. much less deep in air-flow direction. Typically, the air pressure drop is much lower than that of an air-cooled heat sink resulting in less fan power used for the same cooling effect or, with constant fan power, resulting in a better cooling effect.

The skilled person may thus understand that there are several challenges associated with the integration of the cooling unit having a two-phase heat exchanger into a power-electronic system. As mentioned above, the form factor is different from that of an air-cooled heat sink, and the pressure drop is lower; the orientation sensitivity must be respected (e.g. condenser at the top in the case of a gravity driven two-phase heat exchanger); the two-phase heat exchanger of the cooling unit is advantageously clamped in a stack of semiconductor modules, and the arrangement is desired to be compact; to avoid thermal stacking, the air flow through the different cooling units is desired to be substantially in parallel (i.e. parallel connected); and the airflow through the semiconductor modules in the cabinet of the power-electronic system is desired to be in a direction from front to back.

The cooling unit with a two-phase heat exchanger and flow guides suitable for embodiments described herein solves the above described problems and offers the desired advantages discussed above.

Figure 8 shows a two-phase heat exchanger 101 as may be used in a cooling unit suitable for embodiments described herein. For the sake of a better overview, the flow guides are not shown in Figure 8. The heat exchanger 101 is exemplarily shown as being stacked between two semiconductor modules 201 and 202. Typically, the heat exchanger 101 and the two semiconductor modules 201, 202 are stacked in a stacking direction 302 (corresponding to the length direction of the cooling unit 100 as described before) as can be seen in Figure 1. The two semiconductor modules 201, 202 may be part of a power-electronic module arrangement.

As employed in some embodiments described herein, the heat exchanger 101 includes a base plate 110 configured for being in contact with a first semiconductor module 201 at a first side 123 of the base plate 110 in length direction 302. Typically, the base plate 110 may be configured for being in contact with a semiconductor module by adapting the geometry of the base plate to the geometry of a semiconductor module. For instance, the base plate 110 and the semiconductor module 201 may have mating surfaces, which may be in contact which each other. The base plate 110 may have a substantially planar surface, in particular at the first side 123, for being in contact with a semiconductor module. Typically, the contact between the base plate 110 and the heat exchanger device allows for conducting heat between the two elements.

The term "substantially" as used herein may mean that there may be a certain deviation from the characteristic denoted with "substantially." For instance, the term "substantially planar" refers to an element which may have certain deviations from the exact planar shape, such as a deviation from the planar shape of about 1° to about 10°. A further example may be a flow path running substantially in one direction. The flow path running substantially in one direction may also include a deviation of about 1° to about 10° from the one direction.

As can be seen in Figure 1, the two-phase heat exchanger 101 is arranged in a stack of semiconductor modules 201, 202, which are stacked in a stacking direction 302 (corresponding to the length direction of the cooling unit). Typically, the two-phase heat exchanger is arranged essentially in a plane normal to the stacking direction of the semiconductor stack, such as a plane extending in the width-depth direction (e.g. a plane spanned by directions 301 and 303). The plane, in which the two-phase heat exchanger is typically arranged, includes the first side 123 of the base plate 110 of the two-phase heat exchanger. Typically, the first side 123 of the base plate 110 substantially runs in the width direction 301.

As employed in some embodiments described herein, the heat exchanger further includes at least one tube element 120 for a first cooling medium or working medium (both terms are used synonymously in the description). The first cooling medium may be a liquid suitable for evaporating at the temperature ranges, which occur in a power-electronic module arrangement (in particular, the first cooling medium evaporates at temperatures less than temperatures occurring in power-electronic module arrangements due to the temperature gradient between the module and the fluid). Typically, the tube element 120 is a closed element for letting circulate the first cooling medium in it.

The first cooling medium or working medium suitable for some embodiments described herein may be a two-phase fluid having a saturation temperature in a range of typically between about 40°C and about 100 °C, more typically between about 70°C and about 90°C, and even more typically of about 80°C. The temperature range occurring in a power-electronic module may be between about 40°C to about 150 °C. The first cooling medium or working medium may have a saturation temperature lower than the occurring peak temperatures in the power-electronic module. Typical peak temperatures (junction temperatures) in semiconductor modules may be between about 100°C to about 175 °C.

As employed in embodiments, the first cooling fluid may at least be one of the group of_ R134a, R245fa, R1234yf, and R1234ze.

The tube 120 extends in the evaporator portion 121 of the cooling unit and the condenser portion 122 of the cooling unit and has, correspondingly, at least one evaporator channel in the evaporator portion 121 and at least one condenser channel in the condenser portion 122. In the example shown in Figure 8, the tube includes two evaporator channels in the evaporator portion 121 of the cooling unit. Further, the tube 120 includes six condenser channels in the condenser portion 122 of the cooling unit in the example shown in Figure 8. The skilled person may understand that the number of evaporator channels and condenser channels is not limited to the shown examples and that any suitable number of evaporator channels and condenser cannels may be chosen.

Typically, the evaporator channel(s) and the condenser channel(s) are in contact with each other so that the first cooling medium or working medium can pass through the channels and may evaporate and condense in the channels. The skilled person may understand that the evaporation and condensation takes place in a certain region or portion of the tube element. The exact place of evaporation and condensation may be dependent on the exact temperature, the working medium used, the detailed tube geometry, the cooling outside the two-phase heat exchanger device and the like. However, the skilled person may understand that the evaporator channel(s) is named as evaporator channel since the bigger part of evaporation takes place in the evaporator channel. The same applies mutatis mutandis for the condenser channel(s). Also, the evaporator channel(s) may contain liquid working medium and gaseous working medium during operation. The same applies to the condenser channels(s): the condenser channel(s) may contain liquid working medium and gaseous working medium during operation.

As employed in some embodiments, the tube 120 may be sectioned in channels. The channels (as can exemplarily be seen in Figure 8) within the tube element 120 are arranged running along a depth direction 303 of the heat exchanger 101. As employed in some embodiments, the evaporator channel(s) and the condenser channel(s) are aligned substantially in parallel to each other in the tube 120. The tube 120 may include separation walls separating the single channels from each other. Typically, for allowing the first cooling medium to flow between the channels, the separation walls do not extend over the whole depth of the tube element 120. As employed in some embodiments, the channels may be connected together with a manifold (for example, a circular tube or stacked plate with openings).

As employed in some embodiments, the tube 120 may be a multi-port extruded tube including the evaporator channel(s) and the condenser channel(s). Typically, condenser channel(s) and evaporator channel(s) may be channels of the same MPE tube. Thus, the multi-port extruded tube allows for avoiding separate tubes for evaporator channel(s) and condenser channel(s). Hence no welding is needed, and a cheap production of the heat exchanger device as employed in some embodiments described herein becomes possible.

As employed in some embodiments, the evaporator channels of the two-phase heat exchanger are placed nearer to the first side 123 of the base plate 110 than the condenser channel(s). In other words, the evaporator channel(s) are placed nearer to the first semiconductor module 201 (with which the base plate 110 of the heat exchanger 101 typically stands in contact).

The base-plate 110 may typically be made of a (highly) thermally conductive material such as aluminum, brazeable aluminum, or copper. The base plate may be manufactured using extrusion, casting, machining or a combination of such common processes. The base-plate may typically not be made to the exact size of the tube element. In particular, the base plate 110 may be made larger than the tube 120 in length direction 302 in order to increase thermal capacitance to the system, as can exemplarily be seen in Figure 8.

As employed in some embodiments described herein, the base plate 110 may have a groove 114 containing the tube 120. Figure 9 shows an enlarged view of the base plate 110, the groove and the tube element 120 in the groove. Typically, a first groove portion 111 in the base plate 110 is dimensioned for enabling thermal contact between the base plate 110 and the tube section extending in the evaporator portion 121 of the cooling unit. In other words, the tube element is partially thermally connected to the base plate. Typically, the tube and the base plate can exchange heat in the region of the evaporator portion of the cooling unit. Heat transferred from the base plate 110 to the evaporator channels of the tube may cause the working medium within the tube channels to evaporate in the evaporator channels.

The thermal contact between the base plate 110 and the tube element 120 in the evaporator portion of the cooling unit may be provided by a direct physical contact between the base plate and the tube element. As employed in some embodiments, the contact between the tube element 120 and the base plate 110 may be provided via an additional material between the base plate 110 and the first or evaporator portion 121 of the tube element 120, in particular a material for increasing the thermal contact between the tube 120 and the base plate 110. As employed in some embodiments, the connection between the first portion of the tube elements may be established by brazing. The tube elements, and in particular the first portion of the tube elements may be clad with a brazing agent. During brazing, the brazing agent melts and establishes a good thermal connection between the first portion of the tube element and the base plate.

Also, apart from a good thermal conductivity between the tube element 120 and the base plate 110 in the evaporator portion 121 of the cooling unit, the first groove portion 111 may ensure a proper fixing of the tube element in the base plate 110 and may be dimensioned accordingly. For instance, the groove 114 of the two-phase heat exchanger may have a length in stacking direction 302 of between about 10 mm and about 100 mm, more typically between about 10 mm and about 70 mm, and even more typically between about 15 mm and about 50 mm. The first portion 111 of the groove 114 may have a length in stacking direction 302 of between about 0.1 and about 1 cm.

The groove further includes a second groove portion 112, which is dimensioned to form a gap 113 between the base plate 110 and at least a part of the condenser portion 122 of the cooling unit for thermal separation of the base plate 110 and the tube in the condenser portion 122 of the cooling unit. As employed in some embodiments, the gap may surround a part of the extension of the second or condenser portion 122 in the depth direction 303. In particular, the part of the second portion being surrounded by the gap may typically include about 10% to about 60%, more typically between about 20% and about 50% and even more typically between 20% and 40% of the whole extension of the second portion of the tube in depth direction 303. Thermal separation may mean that substantially no heat exchange takes place between the thermally separated elements, e.g. the tube element 120 in the condenser portion 122 of the cooling unit and the base plate 110. For instance, the gap 113 may offer a thermal separation between the second portion of the tube elements and the base plate.

As employed in some embodiments, the first groove portion 111 is narrower than the second groove portion 112, especially for realizing the thermal contact between the tube 120 in the evaporator portion 121 of the cooling unit and the base plate 110 and for avoiding thermal contact between the tube 120 in the condenser portion 122 of the cooling unit and the base plate 110. Typically, the extension of the first groove portion 111 in width direction 301 may be between about 0.2 cm and about 1 cm. The extension of the second groove portion 112 in width direction 301 may be between about 0.4 cm and about 1.2 cm. Typically, the gap size 116 of the gap 113 may be measured as the shortest distance between the tube 120 and the second groove portion 112 of the groove 114. The gap size 116 may be measured substantially perpendicular to the second groove portion 112 and the tube 120. As employed in some embodiments, the gap size 116 may typically be larger than about 0.5 mm, more typically be equal to or larger than about 1 mm, and even more typically equal to or larger than 1.5 mm, such as about 2 mm.

As employed in some embodiments, the two-phase heat exchanger device 100 as described herein may be a passive two-phase heat exchanger. As employed in some embodiments, the two-phase heat exchanger is one of: gravity-driven thermosyphon; pulsating heat pipe; capillary pumped loop or loop heat pipe.

If a gravity-driven thermosyphon is used, the condenser channel(s) may advantageously be above the evaporator channel(s) in vertical direction, i.e. the gravity-driven thermosyphon is substantially vertically oriented. As employed in some embodiments described herein, this means that the stacking direction may be substantially horizontal.

As employed in some embodiments described herein, the tube elements used in a heat exchanger device suitable for embodiments described herein may be configured and dimensioned to cause convection boiling of the first cooling medium in the tube elements, especially the evaporator portion of the tube element. The skilled person may understand that heat is taken away from the tube wall surface by conduction through a liquid refrigerant film at the tube wall for convection boiling. The liquid refrigerant, such as the first cooling medium, is led through the tube element having a confined width for preventing pool boiling. Pumping or bubble pumping may increase the velocity of the vapor stream within the tube element. With pool boiling, on the other hand, heat is taken away from the wall surface by continuous nucleating vapor bubbles that slowly hover off the wall surface for gravity reasons. The thermal efficiency is higher with convection boiling than pool boiling, because the velocity of the vapor stream and the vapor quality is higher than in pool boiling situations. The reasons are that the vapor is removed comparatively quickly from the spot where vaporization took place and the liquid refrigerant neighboring the vapor stream is not heated up that much with convection boiling. As a result, the thermal energy content of the vapor derived by convective boiling is higher than in a pool boiling situation. The difference between pool boiling and convection boiling is schematically shown in Figure 11 (pool boiling) and Figure 12 (convection boiling). Figures 11 and 12 show a section of a tube element 120 in the evaporator portion 121. In the Figures 11 and 12, the pool boiling shows bubbles of vapor in the liquid cooling medium 132. The convection boiling shown in Figure 12 shows a film of liquid cooling medium 132 at the wall of the tube element 120 and a stream of vaporized cooling medium 133 in the middle part of the tube element 120. The skilled person may understand that the liquid cooling medium 132 and the vaporized cooling medium 133 are different states of the first cooling medium 131.

As employed in some embodiments, instead of the gravity-driven thermosyphon, a pulsating heat pipe may be used. An example of an implementation includes a pulsating loop heat pipe. The pulsating heat pipe may have the same external shape as the gravity-driven thermosyphon. Since the two-phase flow is driven by pressure pulsations in the pulsating heat pipe (rather than gravity), the pulsating heat pipe is substantially independent from the orientation. The pulsating heat pipe may also be used in a substantially horizontal orientation. This enables a vertical stacking direction.

Figure 10 shows a two-phase heat exchanger of a cooling unit suitable for embodiments described herein. The base plate 110 has grooves 114 that receive the tube 120. In Figure 10, only one tube 120 is shown, although several tube elements may be provided, as can exemplarily be seen in Figure 8. The groove has a first groove portion 111 in the evaporator portion 121 of the cooling unit. The tube 120 may include an evaporator channel 125 in the evaporator portion 121 of the cooling unit. For the sake of a better overview, only one large evaporator channel is shown, although the skilled person may understand that there may be more than one evaporator channel, especially more than one smaller evaporator channel than the one shown in Figure 10. As employed in some embodiments, the tube 120 may be a multi-port extruded (MPE) tube through which the working medium, or first cooling medium, flows.

As employed in some embodiments, the wall thicknesses of a multi-port extruded flat tube may be between about 0.2 to about 0.75 mm. The material of the tube may be aluminum or the like. As employed in some embodiments, the tubes as referred to herein may be configured for withstanding a pressure of about 100 bars. In particular, the wall thickness may be chosen accordingly. The first cooling medium may have a pressure between about 0.1 bar and about 30 bar in typical applications of the two-phase heat exchanger device for semiconductor modules suitable for embodiments described herein.

In the example shown, the first topmost channel 125 in the tube 120 is an evaporator channel that is thermally in contact with the base plate 110. The remaining channels of the condenser portion 122 of the cooling unit are condenser channels 126 and are not in thermal contact with the base plate 110 suitable for some embodiments described herein. Arrows 131 denote the working medium 131, also denoted as the first cooling medium 131, flowing through the evaporator channel 126. At the condenser portion 122 of the cooling unit including the condenser channels 126, the grooves 114 are wider such that direct contact and heat transfer of the base plate 110 with the condenser channels 126 is avoided. In particular, for adapting the two-phase heat exchanger device to a stack of semiconductor modules, the base plate is thicker in stacking direction compared to known systems. Also, the grooves 114 in the base plate 110 are designed deeper as compared to known systems. As employed in some embodiments, the grooves especially provide a greater extension in stacking direction than the tube 120, which can best be seen in Figure 8. With the design of deeper grooves as employed in some embodiments described herein, semiconductor modules can be clamped from both sides.

As may be employed in some embodiments, and exemplarily shown in Figure 10, fins 150 may be provided at the tube 120 in the condenser portion 122 of the cooling unit on the outer side of the tube 120. The outer side of the tube 120 may be understood as the side, where the first cooling medium does not flow. The fins 150 are typically provided above the gap 113 in the depth direction 303 or at a part of the condenser portion of the tube element not surrounded by the gap 113. As employed in some embodiments described herein, the fins increase the heat exchange and support the condensation of the working medium or first cooling medium 131 in the condenser channels 126 of the tube 120. In the example shown in Figure 10, only three fins 150 are shown at each side of the tube element for the sake of a better overview. However, the skilled person may understand that the number of the fins may vary and may be adapted to the respective application. For instance, the number of fins on each side may be larger than 3, such as larger than 5, or even larger than 10.

The fins 150 may be cooled by a convective flow of an external cooling medium 130, such as air. For instance, the flow of the external cooling medium 130 may be guided by flow guides as explained in detail above. The flow of the second cooling medium 130 may e.g. be generated by a cooling fan or blower (not shown). Furthermore, the fins may be provided in the shape of louvered fins. Louvered fins may used to increase the heat-transfer coefficient without significant increase in pressure drop (louvers are twisted slits on the fin's surface). Generally, the fins may be cut from a strip of sheet aluminum and bent into an accordion-like shape as shown in Figure 10. The pitch between the fins can be easily adjusted to the size of the two-phase heat exchanger and the respective intended application of the heat exchanger.

The skilled person may understand that the fins, although described and shown in an accordion-like shape, may have any suitable shape for increasing the heat transfer from the condenser portion 122 of the cooling unit to the external (or second) cooling medium 130, such as simple sheets of metal, folded sheets of metal in various shapes and the like.

As employed in some embodiments, smaller channels with dividing walls or additional fin-like features on the inner-wall surfaces may be used for the condenser channels 126 of the tube 120, especially to increase the inner channel surface, thereby increasing the heat-transfer surface. Furthermore, as employed in some embodiments, flat tubes may be used as channels in the tube element causing less pressure drop to the flow of external cooling medium 130 compared to round tubes.

According to the invention, a power-electronic module arrangement including a cooling unit is provided. The power-electronic module arrangement includes a plurality of semiconductor modules 200 stacked in a stacking direction 302 and a plurality of two-phase heat exchangers, as described above, of cooling units. Typically, each semiconductor module 200 is in contact with at least one two-phase heat exchanger, as can for instance be seen in the Figures 2 to 7. According to some embodiments, the two-phase heat exchanger may be described as being clamped between the semiconductor modules 200. In particular, the two-phase heat exchanger 101 may be clamped to one of the semiconductor modules 200 essentially in a plane normal to the stacking direction 302, for instance in a depth-width-plane spanned by directions 301 and 303.

The flow guides 141, 142 of the cooling units of the plurality of cooling units block the flow of the external cooling medium 130 at one side of a two-phase heat exchanger 101 in stacking direction 302, in particular at a first position of the two-phase heat exchanger 110 in depth direction 303. As can be seen in Figure 1, the flow guide 141 is arranged at one side of the two-phase heat exchanger 101 in stacking direction 302 and at one side (or one end) of the two-phase heat exchanger 101 in depth direction 303. The two flow guides 141 and 142 in Figure 1 may be described as being shifted in depth direction 303 as well as in stacking direction 302.

According to the invention, the flow guides 141, 142 of the cooling units 100 of the plurality of cooling units block the flow of cooling medium between neighboring cooling units 100 alternately at a first side 161 of the cooling unit 100 in depth direction 303 and a second side 162 of the cooling unit 100 opposite to the first side 161 in the depth direction 303. Figure 3 shows an arrangement, where the flow guides 141 and 142 block the flow 130 alternately at a first end of the two-phase heat exchanger in depth direction 303 and at a second end of the two-phase heat exchanger in depth direction 303.

In some embodiments, the power-electronic module arrangement further includes a cabinet for the power-electronic module arrangement for allowing an external cooling medium 130 to enter the cabinet from the front direction corresponding substantially to a depth direction 301 of the cooling unit 100 for cooling the condenser portion 122 of the cooling unit. The second cooling medium entering the cabinet in depth 303 direction may include that the second cooling medium crosses a plane formed by depth direction 303 and width direction 301 (thus flowing substantially parallel to direction 302, as can exemplarily be seen in Figures 2 and 3.

The cabinet (not shown) of the power-electronic module arrangement may include front doors, through which the second cooling medium 130 may be guided to reach the two-phase heat exchanger. Also, fans or the like may be provided for conveying the second cooling medium into and out of the cabinet.

As employed in some embodiments, a power-electronic converter arranged in a cabinet is provided. Typically, the power-electronic converter comprises at least one semiconductor stack with at least one semiconductor module and at least two two-phase coolers. Typically, the two-phase coolers may be two two-phase heat exchanger devices as described above. The two-phase cooler may be of an essentially planar shape, especially a planar outer shape, and includes an evaporator portion and a condenser portion. Alternatively or additionally, each two-phase cooler includes at least one tube having multiple channels, wherein at least one channel is used to evaporate a two-phase medium, and at least one channel is used to condensate the two-phase medium back to liquid. In the power-electronic converter as employed in some embodiments described herein, the evaporators of the two-phase coolers may be clamped to the at least one semiconductor module in stacking direction in the stack of semiconductor modules. Typically, the condenser portion of the two-phase cooler may additionally be air cooled. The cooling air may enter the cabinet, in which the power-electronic converter is located, from the front direction (which may be, according to some embodiments, the depth direction of the two-phase cooler). As employed in some embodiments, the power-electronic converter includes air guides in the cabinet, arranged such that the cooling air is flowing through the at least two condenser portions of the two-phase cooler in parallel, thereby avoiding thermal stacking. Thermal stacking generally appears when several semiconductor modules are cooled by a cooling fluid, which passes the semiconductor modules consecutively so that the cooling fluid is continuously heated up.

As employed in some embodiments, which may be combined with other embodiments described herein, the two-phase coolers are passive. Typically, a two-phase cooler as referred to herein may be one of: a gravity-driven thermosyphon; a pulsating heat pipe; a capillary pumped loop or a loop heat pipe. In the power-electronic converter as employed in embodiments described herein, the stacking direction of the stack of semiconductor modules is substantially normal to the front-back direction of the cabinet, in which the power-electronic converter is arranged. The front-back direction of the cabinet may thus run substantially along the depth direction of the two-phase coolers. As employed in some embodiments, the two-phase coolers are arranged substantially in a plane normal to the stacking direction. This may mean that the two-phase coolers are arranged facing each other. In particular, two planes extending in the depth-width direction of adjacent two-phase coolers may face each other.

As employed in some embodiments, the air guiding is substantially effected by blocking parts of the flow cross-section in front of the condenser portions and behind the condenser portions (in particular in depth direction of the two-phase coolers). Blocking parts of the flow cross-section of the air flow in the described manner may force the air to pass through the condenser portions in stacking direction (i.e. in length 302 direction of the two-phase coolers). As employed in some embodiments, blocking parts of the flow cross-section of the air flow in the described manner causes the air flow to firstly flow in front-back direction of the cabinet towards the stack of semiconductor modules (such as depth direction 303 in Figures 5 and 6), then to flow in stacking direction through the condenser portions (such as in stacking direction 302 crossing the plane formed by the directions 303 and 301 as can be seen in Figure 5), and then to flow further towards the back (e.g. again substantially in depth direction 303). The flow path of the second cooling medium (e.g. the air), may hence substantially follow an S-shaped path, as shown in Figure 6.

As employed in some embodiments, the condenser portions are of fin-and-tube type, e.g. for increasing the cooling effect of the second cooling medium.

The skilled person may understand that the above described embodiments herein provide several benefits. For instance, a standard, planar base-to-air two-phase heat exchanger may be used, which reduces costs. Further, like in air cooling systems with heat sinks, the cooling units may be on potential, and air may be used as electrical insulation. An electrical insulation in the cooling unit is saved, making the cooling unit according to embodiments described herein still further cheap.

As discussed in detail above, in particular with respect to Figures 2 to 7, the cooling unit as employed in embodiments described herein offers flexibility. The arrangement of the cooling unit with the heat exchanger and the flow guides as such can flexibly be designed, as well as a power-electronic module arrangement having a plurality of semiconductor modules and heat exchangers. Additionally, the two-phase heat exchanger may be designed less thick than an air-cooled heat sink as used in known systems. Thus, the length of the stack in stacking direction can be reduced (in particular, length in the case of a horizontal stacking, height in the case of vertical stacking). The reduction can be used to compensate for the additional height used for the condenser portion of the cooling unit.

As employed in some embodiments, the cooling power can be adapted playing with the width in direction 301 of the condenser portion, leaving the length (in direction 302) of the stack of semiconductor modules unaffected.

As employed in some embodiments, a first example of the two-phase heat exchanger of the cooling unit may include a base plate (110) configured for being in contact with a first semiconductor module (201) at a first side (123) of the base plate (110), at least one tube element (120) for the first cooling medium (131), the tube element including a first or evaporator portion (121) having at least one evaporator channel and a second or condenser portion (122) having at least one condenser channel. Typically, the base plate (110) may have a groove (111; 112) containing the tube element (120) and the groove (111; 112) may be dimensioned for enabling thermal contact between the base plate (110) and the first or evaporator portion (121) of the tube element. Further, the groove (111; 112) may be dimensioned to form a gap (113) between the base plate (110) and at last a part of the second or condenser portion (122) of the tube element (120) for thermal separation of the base plate (110) and the second portion (122) of the tube element (120). In a second example, which may be combined with the first example, the thermal contact between the first portion (121) of the tube element (120) and the base plate (110) may be enabled by a physical contact between the base plate (110) and the first portion (121) of the tube element (120) in the groove (111), wherein in particular the physical contact may be provided by direct contact between the base plate (110) and the first portion (121) of the tube element (120) or via an additional material between the base plate (110) and the first portion (121) of the tube element (120). In a third example, which may be combined with the first and/or second example, the groove may have a first groove portion (111) for receiving the first or evaporator portion (121) of the tube element (120) and a second groove portion (112) for receiving the second portion (122) of the tube element (120), wherein the first portion (111) of the groove may be narrower than the second portion (112) of the groove. In a fourth example, which may be combined with at least one of the first to third example, the groove (111; 112) may be formed as an extruded slot in the base plate (110). In a fifth example, which may be combined with at least one of the first to fourth example, the two-phase heat exchanger device may be configured for being clamped between the first semiconductor module (201) at the first side (123) of the base plate (110) and a second semiconductor module (202) at a second side of the base plate (110). In a sixth example, which may be combined with at least one of the first to fifth example, the two-phase heat exchanger device may be a passive two-phase heat exchanger and/or may be one of: gravity-driven thermosyphon; pulsating heat pipe; capillary pumped loop or loop heat pipe. In a seventh example, which may be combined with at least one of the first to sixth example, the two-phase heat exchanger device may be adapted for being arranged in a stack of semiconductor modules stacked in a stacking direction (302), wherein the two-phase heat exchanger may essentially be arranged in a plane normal to the stacking direction of the semiconductor stack, the plane comprising the first side (123) of the base plate (110). In an eighth example, which may be combined with at least one of the first to seventh example, fins (150) may be attached to the second portion (122) of the tube element (120) on the outer side of the tube element (120). In a ninth example, which may be combined with at least one of the first to eighth example, the at least one tube element may be a multi-port extruded tube comprising the at least one evaporator channel and the at least one condenser channel. In a tenth example, which may be combined with at least one of the first to ninth example, the base plate (110) comprising the at least one tube element may have planar exterior sidewalls at least at the first side (123) and a second side (124) opposite to the first side, wherein in particular the planar exterior sidewall at the second side of base plate (110) may be interrupted by the opening of the groove. In an eleventh example, which may be combined with at least one of the first to tenth example, the at least one evaporator channel and at least one condenser channel may be aligned in parallel to each other in the tube element (120). In a twelfth example, which may be combined with at least one of the first to eleventh example, the at least one evaporator channel may be placed nearer to the first side (123) of the base plate than the condenser channel. According to a further, 13^{th} example, a power-electronic module arrangement may be provided including a stack of semiconductor modules and a plurality of heat exchangers according to any of the first to twelfth example described herein clamped between the semiconductor modules. In a 14^{th} example, the power-electronic module arrangement according to the 13^{th} example may further include flow guides (141; 142) for forcing an external second cooling medium (130) arriving to the heat exchanger device from outside of the heat exchanger device to pass the second portion (122) of the tube element (120) and then away from the heat exchanger device. In a 15^{th} example, which may be combined with at least one of the 13^{th} to 14^{th} example, the power-electronic module arrangement may further include a cabinet for the power-electronic module arrangement for allowing the external second cooling medium (130) to enter the cabinet from the front direction corresponding substantially to a width direction (301) of the heat exchanger device for cooling the second portion (122) of the tube element (120) of the heat exchanger device.

Though the present invention has been described on the basis of embodiments, those skilled in the art should appreciate that those embodiments should by no way limit the scope of the present invention. Without departing from the concept of the present invention, any variations and modifications to the embodiments should be within the apprehension of those with ordinary knowledge and skills in the art, and therefore fall in the scope of the present invention which is defined by the accompanied claims.

### Reference numerals

- 100: cooling unit
- 101: two-phase heat exchanger
- 110: baseplate
- 111: first portion of the groove
- 112: second portion of the groove
- 113: gap
- 114: groove
- 116: gap size
- 120: tube element
- 121: evaporator portion of the cooling unit
- 122: condenser portion of the cooling unit
- 123: first side of cooling unit in stacking direction
- 124: second side of cooling unit in stacking direction
- 125: evaporator channel of the tube element
- 126: condenser channel of the tube element
- 130: external (second) cooling medium
- 131: working fluid, first cooling medium
- 141, 142: flow guides
- 150: fins
- 161: first side of cooling unit in depth direction
- 162: second side of cooling unit in depth direction
- 200, 201, 202: semiconductor modules
- 213: flow path
- 300: arrangement
- 301: width direction
- 302: length direction, stacking direction
- 303: depth direction

## Claims

1. A power-electronic module arrangement comprising
- a plurality of cooling units (100), the cooling units each comprising:
a two-phase heat exchanger (101) comprising a plurality of tube elements (120) extending in a width direction (301) of the cooling unit (100), within and
communicating between an evaporator portion (121) and a condenser portion (122) of the cooling unit (100),
wherein the tube elements (120) are arranged in a spaced-apart manner along a depth direction (303) of the cooling unit (100) forming cooling paths (213) for allowing an external cooling medium (130) to flow through the cooling paths (213) for cooling a working medium within the at least one tube element (120), the cooling paths (213) traversing the condenser portion (122) in a length direction (302) of the cooling unit (100); and
flow guides (141; 142) for forcing an external cooling medium (130) arriving at the heat exchanger (101) from outside of the cooling unit (100) through the cooling paths (213) and then away from the cooling unit (100),
wherein a plurality of semiconductor modules (200) is stacked in a length direction (302) of each cooling unit (100),
**characterized in that** the flow guides (141; 142) of the cooling units (100) block the flow of the cooling medium (130) at one side of a two-phase heat exchanger (101) in length direction (302),
and **in that** the flow guides (141; 142) of the cooling units (100) of the plurality of cooling units block the flow of cooling medium between neighboring cooling units (100) alternately at a first side (161) of the cooling unit (100) in depth direction (303) and a second side (162) of the cooling unit (100) opposite to the first side in the depth direction (303).

2. The power-electronic module arrangement according to claim 1, wherein the two-phase heat exchanger (101) is in contact with the semiconductor modules (200) by being clamped to one of the semiconductor modules essentially in a plane normal to the length direction (302).

3. The power-electronic module arrangement according to any preceding claim, further comprising a cabinet for the power-electronic module arrangement, wherein a cooling medium (130) enters the cabinet from the front direction corresponding substantially to the width direction (301) of the cooling unit (100), for cooling the condenser portions (122) of the cooling unit (100).

4. The power-electronic module arrangement according to any preceding claim, where the two-phase heat exchanger (101) is passive with respect to the working medium, and/or is one of: a gravity-driven thermosyphon; a pulsating heat pipe; a capillary pumped loop or a loop heat pipe.

5. The power-electronic module arrangement according to any preceding claim, wherein the at least one tube element (120) of the two-phase heat exchanger (101) comprises at least one evaporator channel (125) in the evaporator portion (121) of the cooling unit (100) for evaporating a first cooling medium (131) and at least one condenser channel (126) in the condenser portion (122) of the cooling unit (100) for condensing the first cooling medium (131).

6. The power-electronic module arrangement according to any preceding claim, wherein the two phase heat exchanger (101) comprises a base plate (110) in the evaporator portion (121), wherein the at least one tube element (120) of the two-phase heat exchanger (101) is at least partially arranged in a groove (114) in the base plate (110) and partially thermally connected to the base plate.

7. The power-electronic module arrangement according to any preceding claim, wherein the tube elements (120) are in thermal contact with the base plate (110) in the groove (114) in the evaporator portion (121) and wherein a gap (113) is formed between each of the tube elements (120) and the base plate (110) in the condenser portion (122) and/or wherein the extension of the base plate (110) in length direction (302) is larger than the extension of the tube elements (120) in length direction (302).

8. The power-electronic module arrangement according to any preceding claim, wherein the condenser portion (122) of the cooling unit (100) is of the fin-and-tube type having fins (150) extending in the cooling path.

9. The power-electronic module arrangement according to any preceding claim, wherein the at least one tube element (120) is a multi-port extruded tube.

## Patentansprüche

1. Eine Anordnung eines leistungselektronischen Moduls, umfassend
- eine Mehrzahl von Kühleinheiten (100), wobei die Kühleinheiten jeweils umfassen:
einen Zweiphasen-Wärmetauscher (101) umfassend eine Mehrzahl von Rohrelementen (120), die innerhalb von und in Kommunikation zwischen einem Verdampferabschnitt (121) und einem Kondensatorabschnitt (122) der Kühleinheit (100) in einer Breitenrichtung (301) der Kühleinheit (100) verlaufen,
wobei die Rohrelemente (120) in einer beabstandeten Weise entlang einer Tiefenrichtung (303) der Kühleinheiten (100) angeordnet sind und Kühlpfade (213) bilden, um es einem externen Kühlmedium (130) zu ermöglichen, durch die Kühlpfade (213) zu strömen, um ein Arbeitsmedium innerhalb des mindestens einen Rohrelements (120) zu kühlen, wobei die Kühlpfade (213) den Kondensatorabschnitt (122) in einer Längsrichtung (302) der Kühleinheit (100) durchqueren; und
Strömungsführungen (141; 142), um ein externes Kühlmedium (130), das am Wärmetauscher (101) von außerhalb der Kühleinheit (100) eintrifft, durch die Kühlpfade (213) und dann von der Kühleinheit (100) weg zu zwingen,
wobei eine Mehrzahl von Halbleitermodulen (200) in einer Längenrichtung (302) jeder Kühleinheit (100) gestapelt ist,
**dadurch gekennzeichnet, dass** die Strömungsführungen (141; 142) der Kühleinheiten (100) den Strom des Kühlmediums (130) an einer Seite des Zweiphasen-Wärmetauschers (101) in Längsrichtung (302) blockieren,
und dass die Strömungsführungen (141; 142) der Kühleinheiten (100) der Mehrzahl von Kühleinheiten den Strom von Kühlmedium zwischen benachbarten Kühleinheiten (100) abwechselnd an einer ersten Seite (161) der Kühleinheit (100) in Tiefenrichtung (303) und an einer zweiten Seite (162) der Kühleinheit (100) gegenüber der ersten Seite in der Tiefenrichtung (303) blockieren.

2. Die Anordnung eines leistungselektronischen Moduls nach Anspruch 1, wobei der Zweiphasen-Wärmetauscher (101) mit den Halbleitermodulen (200) in Kontakt ist, indem er an eines der Halbleitermodule im Wesentlichen in einer zur Längsrichtung (302) senkrechten Ebene geklemmt ist.

3. Die Anordnung eines leistungselektronischen Moduls nach einem der vorstehenden Ansprüche, weiter umfassend ein Gehäuse für die Anordnung eines leistungselektronischen Moduls, wobei ein Kühlmedium (130) von der vorderen Richtung, die im Wesentlichen der Breitenrichtung (301) der Kühleinheit (100) entspricht, in das Gehäuse eintritt, um die Kondensatorabschnitte (122) der Kühleinheit (100) zu kühlen.

4. Die Anordnung eines leistungselektronischen Moduls nach einem der vorstehenden Ansprüche, wobei der Zweiphasen-Wärmetauscher (101) in Bezug auf das Arbeitsmedium passiv und/oder eines der folgenden ist: ein schwerkraftgetriebener Thermosiphon; ein pulsierendes Wärmerohr; eine gepumpte Kapillarschleife oder eine Wärmerohrschleife.

5. Die Anordnung eines leistungselektronischen Moduls nach einem der vorstehenden Ansprüche, wobei das mindestens eine Rohrelement (120) des Zweiphasen-Wärmetauschers (101) mindestens einen Verdampferkanal (125) im Verdampferabschnitt (121) der Kühleinheit (100) umfasst, um ein erstes Kühlmedium (131) zu verdampfen, und mindestens einen Kondensatorkanal (126) im Kondensatorabschnitt (122) der Kühleinheit (100) zum Kondensieren des ersten Kühlmediums (131).

6. Die Anordnung eines leistungselektronischen Moduls nach einem der vorstehenden Ansprüche, wobei der Zweiphasen-Wärmetauscher (101) eine Basisplatte (110) im Verdampferabschnitt (121) umfasst, wobei das mindestens eine Rohrelement (120) des Zweiphasen-Wärmetauschers (101) zumindest teilweise in einer Rille (114) in der Basisplatte (110) angeordnet und zumindest teilweise mit der Basisplatte thermisch verbunden ist.

7. Die Anordnung eines leistungselektronischen Moduls nach einem der vorstehenden Ansprüche, wobei die Rohrelemente (120) in thermischem Kontakt mit der Basisplatte (110) in der Rille (114) im Verdampferabschnitt (121) sind und wobei ein Spalt (113) zwischen jedem der Rohrelemente (120) und der Basisplatte (110) im Kondensatorabschnitt (122) gebildet wird und/oder wobei die Erweiterung der Basisplatte (110) in Längsrichtung (302) größer ist als die Erweiterung der Rohrelemente (120) in Längsrichtung (302).

8. Die Anordnung eines leistungselektronischen Moduls nach einem der vorstehenden Ansprüche, wobei der Kondensatorabschnitt (122) der Kühleinheit (100) vom Rippe-und-Rohr-Typ ist und Rippen (150) aufweist, die in den Kühlpfad verlaufen.

9. Die Anordnung eines leistungselektronischen Moduls nach einem der vorstehenden Ansprüche, wobei das mindestens eine Rohrelement (120) ein extrudiertes Mehrwege-Rohr ist.

## Revendications

1. Un agencement de module électronique de puissance comprenant
une pluralité d'unités de refroidissement (100), les unités de refroidissement comprenant chacune :
un échangeur de chaleur à deux phases (101) comprenant une pluralité d'éléments de tube (120) s'étendant dans une direction de la largeur (301) de l'unité de refroidissement (100), à l'intérieur et en communication entre une partie d'évaporateur (121) et une partie de condenseur (122) de l'unité de refroidissement (100),
les éléments de tube (120) étant disposés de manière espacée le long d'une direction de la profondeur (303) de l'unité de refroidissement (100) formant des trajets de refroidissement (213) pour permettre à un milieu de refroidissement externe (130) de circuler à travers les trajets de refroidissement (213) pour refroidir un milieu de travail à l'intérieur de l'au moins un élément de tube (120), les trajets de refroidissement (213) traversant la partie de condenseur (122) dans une direction de la longueur (302) de l'unité de refroidissement (100) ; et
des guides d'écoulement (141 ; 142) pour forcer un milieu de refroidissement externe (130) arrivant au niveau de l'échangeur de chaleur (101) depuis l'extérieur de l'unité de refroidissement (100) à travers les trajets de refroidissement (213) puis à l'opposé de l'unité de refroidissement (100),
une pluralité de modules semi-conducteurs (200) étant empilés dans une direction de la longueur (302) de chaque unité de refroidissement (100),
**caractérisé en ce que**
les guides d'écoulement (141 ; 142) des unités de refroidissement (100) bloquent l'écoulement du milieu de refroidissement (130) au niveau d'un côté d'un échangeur de chaleur à deux phases (101) dans la direction de la longueur (302),
et **en ce que**
les guides d'écoulement (141 ; 142) des unités de refroidissement (100) de la pluralité d'unités de refroidissement bloquent l'écoulement de milieu de refroidissement entre des unités de refroidissement voisines (100) en alternance au niveau d'un premier côté (161) de l'unité de refroidissement (100) dans la direction de la profondeur (303), et au niveau d'un second côté (162) de l'unité de refroidissement (100), opposé au premier côté dans la direction de la profondeur (303).

2. L'agencement de module électronique de puissance selon la revendication 1, l'échangeur de chaleur à deux phases (101) étant en contact avec les modules semi-conducteurs (200) par serrage sur l'un des modules semi-conducteurs essentiellement dans un plan normal à la direction de la longueur (302).

3. L'agencement de module électronique de puissance selon l'une quelconque des revendications précédentes, comprenant en outre un coffret pour l'agencement de module électronique de puissance, un milieu de refroidissement (130) pénétrant dans le coffret à partir de la direction avant correspondant sensiblement à la direction de la largeur (301) de l'unité de refroidissement (100), pour refroidir les parties de condenseur (122) de l'unité de refroidissement (100).

4. L'agencement de module électronique de puissance selon l'une quelconque des revendications précédentes, l'échangeur de chaleur à deux phases (101) étant passif par rapport au milieu de travail, et/ou étant l'un des éléments suivants : un thermosiphon entraîné par gravité ; un caloduc oscillant ; une boucle à pompage capillaire ou un caloduc en boucle.

5. L'agencement de module électronique de puissance selon l'une quelconque des revendications précédentes, l'au moins un élément de tube (120) de l'échangeur de chaleur à deux phases (101) comprenant au moins un canal d'évaporation (125) dans la partie d'évaporateur (121) de l'unité de refroidissement (100) pour l'évaporation d'un premier milieu de refroidissement (131), et au moins un canal de condenseur (126) dans la partie de condenseur (122) de l'unité de refroidissement (100) pour la condensation du premier milieu de refroidissement (131).

6. L'agencement de module électronique de puissance selon l'une quelconque des revendications précédentes, l'échangeur de chaleur à deux phases (101) comprenant une plaque de base (110) dans la partie d'évaporateur (121), l'au moins un élément de tube (120) de l'échangeur de chaleur à deux phases (101) étant au moins partiellement disposé dans une rainure (114) dans la plaque de base (110) et partiellement relié thermiquement à la plaque de base.

7. L'agencement de module électronique de puissance selon l'une quelconque des revendications précédentes, les éléments de tube (120) étant en contact thermique avec la plaque de base (110) dans la rainure (114) dans la partie d'évaporateur (121), et un espace (113) étant formé entre chacun des éléments de tube (120) et la plaque de base (110) dans la partie de condenseur (122) et/ou l'extension de la plaque de base (110) dans le sens de la longueur (302) étant plus grande que l'extension des éléments de tube (120) dans la direction de la longueur (302).

8. L'agencement de module électronique de puissance selon l'une quelconque des revendications précédentes, la partie de condenseur (122) de l'unité de refroidissement (100) étant du type à ailette et tube ayant des ailettes (150) s'étendant dans le trajet de refroidissement.

9. L'agencement de module électronique de puissance selon l'une quelconque des revendications précédentes, l'au moins un élément de tube (120) étant un tube extrudé à orifices multiples.
